# EUROPEAN PATENT APPLICATION

(11) **EP 4 124 404 A1**
(43) Date of publication of application: **01.02.2023**
(21) Application number: 22185181.9
(22) Date of filing: 15.07.2022
(51) Int. Cl.: B23K 9/10, G01R 31/40, H02M 7/02

(54) **SYSTEM AND METHOD TO DETECT THREE-PHASE INPUT POWER AND CHANGE-OF-PHASE ON THREE-PHASE INPUT POWER**

(30) Priority: 30.07.2021 US 202163227610 P; 14.07.2022 US 202217864681
(71) Applicant: Illinois Tool Works, Inc., Glenview, Illinois 60025 (US)
(72) Inventor: MANTHE, Alan Adam, Glenview, 60025 (US)
(74) Representative: HGF

(57) **Abstract**

An example welding-type power supply includes: power conversion circuitry configured to convert three-phase input power to welding-type power; a reference node coupled to each winding of the three-phase input power via a corresponding impedance; and a phase detection circuit coupled to the reference node and configured to determine a number of phases connected to the input based on comparing a frequency of a signal at the reference node to a threshold frequency.

## Description

### RELATED APPLICATIONS

The present application claims the benefit of U. S. Provisional Patent Application Serial No. 63/227,610, filed July 30, 2021, entitled "SYSTEMS AND METHODS TO DETECT THREE-PHASE INPUT POWER AND CHANGE-OF-PHASE ON THREE-PHASE INPUT POWER." The entirety of U.S. Provisional Patent Application Serial No. 63/227,610 is expressly incorporated herein by reference.

### FIELD OF THE DISCLOSURE

This disclosure is directed generally to welding-type power supplies and, more particularly, to systems and methods to detect three-phase input power and change-of-phase on input power.

### BACKGROUND

Conventional welding-type power sources provide power for welding-type tools. In some systems, a direct current (DC) power bus provides welding-type power for welding-type tools and auxiliary outputs. Welding-type power sources may be supplied with either single-phase or three-phase Alternating Current (AC) input power. Some equipment may be designed to condition the input power differently based on whether the input power is a three-phase AC power supply or a single-phase AC power supply. Therefore, systems and methods to control based on the connection of single-phase AC input power or three-phase AC input power to the welding-type power supply are desirable.

### SUMMARY

Systems and methods to detect three-phase input power and change-of-phase on input power are disclosed, substantially as illustrated by and described in connection with at least one of the figures, as set forth more completely in the claims.

### BRIEF DESCRIPTION OF THE DRAWINGS

FIG. 1 is a block diagram of an example welding-type power supply in accordance with aspects of this disclosure.
FIG. 2 is a circuit diagram representative of the example phase detection circuit connected to the input of FIG. 1
FIG. 3 is a flowchart representative of an example method which may be performed by the welding-type power supply and the phase detection circuit of FIGS. 1 and 2 to detect single-phase or three-phase input power, and to control a welding-type power supply based on the detection.

The figures are not necessarily to scale. Where appropriate, similar or identical reference numbers are used to refer to similar or identical components.

### DETAILED DESCRIPTION

Welding-type power supplies may be supplied with either single-phase or three-phase input power. Some equipment is configured to operate with either three-phase or single-phase power, but may require changes in control scheme to increase efficiency and/or avoid equipment damage when using single-phase or three-phase inputs. On the other hand, some equipment may only be designed to operate with a three-phase supply. This equipment may be subject to damage when operated with a single-phase input if the output power is sufficiently high. Operating from a single-phase requires a higher RMS and peak input current for the same output power. As a result, input rectifier(s), input inductor(s) (or DC link chokes), DC link capacitors, input power cords, and/or other input related circuitry may be thermally stressed under a single-phase condition. Therefore, to protect the equipment from damage, it is advantageous to reduce the effects of, or prevent entirely, single-phase operation in a welding-type power source that is not designed to operate under a single-phase condition.

Conventionally, single-phase operation can be detected using several approaches. Two conventional, direct approaches include measuring phase-to-phase voltages or phase currents of the input. A drawback to these methods is that phase-to-phase voltages or phase currents are not typically measured in a welding-type power supply, and measuring phase-to-phase voltages or phase currents would require additional circuitry and cost to implement. An approach to detect single-phase operation that does not require additional circuitry to be added to the welding-type power supply is therefore desirable.

Disclosed example welding-type power supplies include: power conversion circuitry configured to convert three-phase input power to welding-type power; a reference node coupled to each winding of the three-phase input power via a corresponding impedance; and a phase detection circuit coupled to the reference node and configured to determine a number of phases connected to the input based on comparing a frequency of a signal at the reference node to a threshold frequency.

In some example welding-type power supplies, the reference node is coupled to each winding of the three-phase input power via a respective capacitor. In some examples, the respective capacitor is configured to perform filtering of the input to reduce electromagnetic emissions. Some example welding-type power supplies include control circuitry configured to control the power conversion circuitry based on whether single-phase power or three-phase power is detected on the input. In some examples, the control circuitry is configured to control at least one of an output current of the power conversion circuitry, an output voltage of the power conversion circuitry, an output power of the power conversion circuitry, a thermal shutdown limit, or output load shedding based on whether single-phase power or three-phase power is detected on the input.

In some examples, the signal includes a ripple signal at the reference node. In some examples, the ripple signal at the reference node is AC-coupled to the phase detection circuit. In some examples, the power conversion circuitry is further configured to convert single-phase input power to the welding-type power. In some examples, the control circuitry is configured to, in response to detecting single-phase input power via the phase detection circuit, at least one of output a notification, output an alarm, or disable output by the power conversion circuitry.

Disclosed example methods to determine a number of phases connected to the input of a welding-type power supply involve: providing input power via a three-phase input connection to a welding-type power supply; and determining a number of phases connected to the three-phase input connection based on comparing a frequency of a signal at a reference node to a threshold frequency, coupled to each winding of the three-phase input power via a corresponding impedance.

In some example methods, the reference node is capacitively coupled to each of the phases of the three-phase input connection. Some example methods further involve controlling power conversion circuitry to convert the input power to welding-type power based on the determined number of phases connected to the three-phase input connection. In some example methods, the controlling of the power conversion circuitry involves controlling at least one of the output current of the power conversion circuitry, an output voltage of the power conversion circuitry, an output power of the power conversion circuitry, a thermal shutdown limit, or output load shedding based on whether single-phase power or three-phase power is detected on the three-phase input connection.

In some example methods, the determining of the number of phases connected to the three-phase input connection involves determining that three phases are connected to the three-phase input connection when the ripple frequency is at least the reference frequency. In some example methods, the determining of the number of phases connected to the three-phase input connection involves determining that fewer than three phases are connected to the three-phase input connection when the ripple frequency is less than the reference frequency.

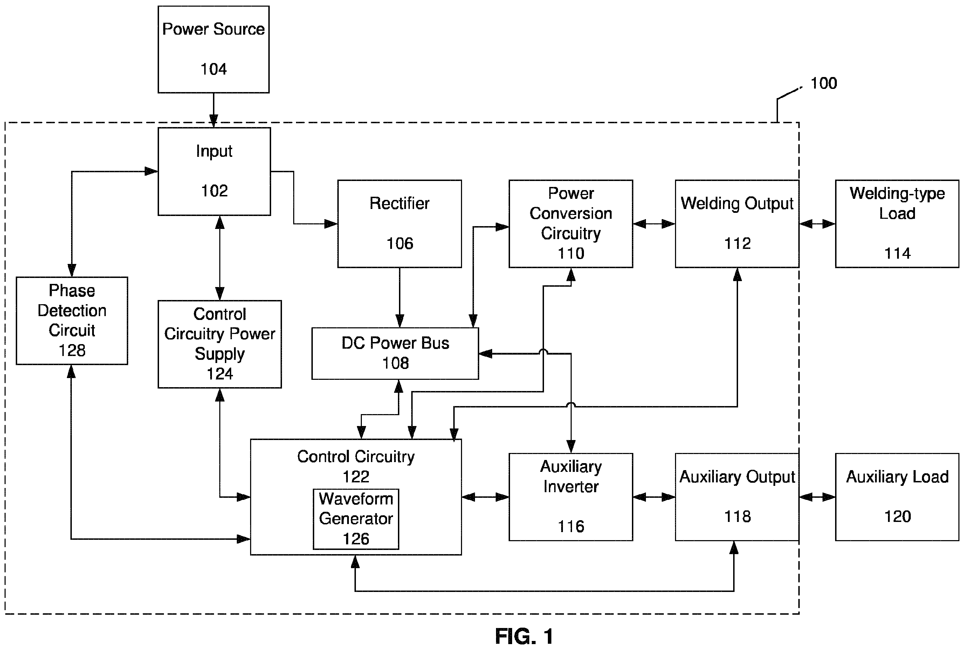

FIG. 1 is a block diagram of an exemplary welding-type power supply 100. The welding-type power supply includes an input 102 configured to receive AC input power from a power source 104. The power source 104 may be the AC power grid, an engine/generator set, or a combination thereof. The power source 104 may provide single-phase AC power or three-phase AC power to the input. The welding-type power supply 100 also includes a rectifier circuit 106 to condition the AC power received at the input 102 to DC power at a DC power bus 108. A power conversion circuitry 110 provides power from the DC power bus 108 to a welding output 112. The welding output 112 provides welding-type power to a welding-type load 114, for example a welding torch. An auxiliary power conversion circuitry 116 provides power from the DC power bus 108 to an auxiliary output 118, which provides power to an auxiliary load 120. Auxiliary type loads may include lighting, small power tools, etc.

Control circuitry 122 is connected to the DC power bus 108, and the power conversion circuitry 110. The control circuitry 122 is powered by a control circuitry power supply 124, which may be, for example, a power transformer that draws power from a single-phase of the AC power connected to the input 102. Alternatively, the control circuitry 122 may be powered by the DC power bus 108.

The control circuitry 122 may include a waveform generator 126. For pulse welding processes (e.g., pulsed MIG or pulsed TIG), the control circuitry 122 may use the waveform generator 126 to control the pulse welding waveform by controlling the power conversion circuitry 110.

When the control circuitry 122 determines that single-phase power is connected to the input, the control circuitry 122 may change a control scheme to adapt to the single-phase power. For example, the control circuitry 122 may derate (e.g., reduce the output capability) of the power conversion circuitry 110 and/or the auxiliary power conversion circuitry 116, perform load shedding, change thermal limits such as shutdown temperatures, control output current, voltage, and/or power, and/or otherwise control the welding-type power supply 100 based on the presence of single-phase input power. Conversely, when the control circuitry 122 determines that three-phase power is connected to the input, the control circuitry 122 may change the control scheme to use the three-phase power (e.g., increased output capability, changed thermal limits, etc.).

In other examples in which the power supply 100 is not configured to use single-phase power effectively, the control circuitry 122 may, in response to detecting the presence of single-phase input, take steps to protect the welding-type power supply 100 and/or equipment powered by the welding-type power supply 100, from damage. In some examples, the control circuitry 122 may power down the welding-type power supply 100 in response to determining that single-phase power is connected to the input 102. Additionally or alternatively, the control circuitry 122 may disable the welding output 112 and/or the auxiliary output 118, and/or may limit the output of the power conversion circuitry 110 to less than a threshold power level. The threshold power level may be a threshold current, a threshold duty cycle, and/or any other threshold power level that limits the heat generated by the rectifier 106, the power conversion circuitry 110, and/or the auxiliary power conversion circuitry 116.

In some examples, the control circuitry 122 may signal an alarm, notification, or other output or annunciation to indicate whether single-phase power or three-phase power is connected to the input 102. For example, the welding-type power supply 100 may include speakers or a display through which an alarm indicating that single-phase power is connected to the input 102 of the welding-type power supply 100 may be signaled to an operator.

To determine whether the power source 104 is a three-phase voltage source or a single-phase voltage source (or a loss of phase has occurred on a three-phase voltage source), the example welding-type power supply 100 further includes a phase detection circuit 128. The phase detection circuit 128 is coupled to the input 102, and determines whether a phase loss has occurred in a three-phase input, or that a single-phase input is attached to the input 102, based on a frequency of a signal derived from a reference node is greater or less than a threshold frequency.

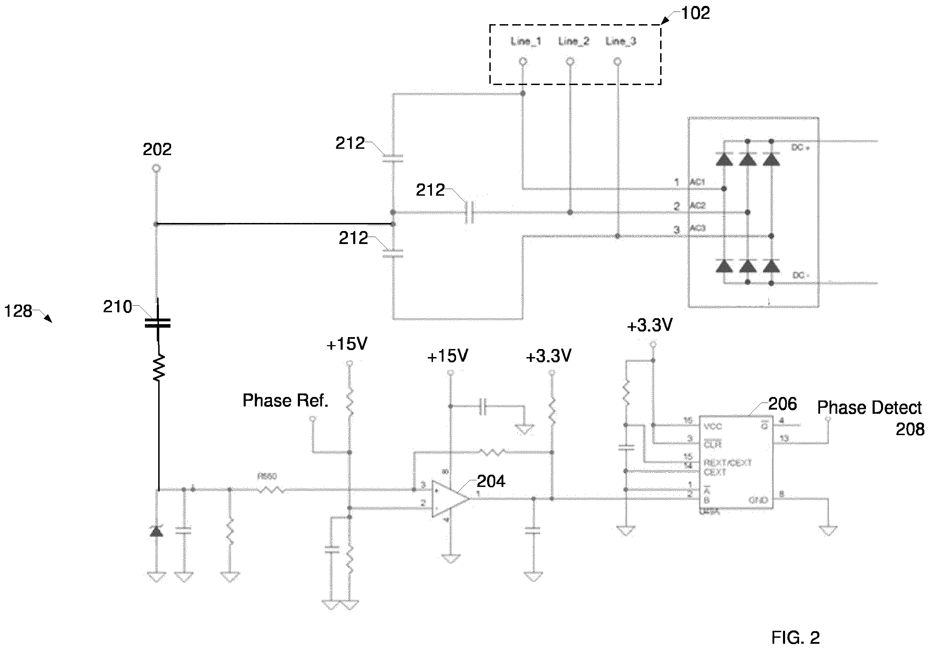

FIG. 2 is a circuit diagram representative of the example phase detection circuit 128 connected to the input 102 of FIG. 1. The input 102 may include three separate terminals for connection of the separate phases of a three-phase input power supply 104. Each phase of the input 102 is further capacitively connected to a reference node 202, which serves as an artificial neutral for the three-phase input power. For each phase of the input 102, a capacitor 212 (e.g., an X-capacitor) is coupled to that phase on a first side and connected to the reference node 202 on a second side of the capacitor. In some examples, the X-capacitors 212 also help filter or reduce electromagnetic emissions by the power supply 100 to improve compliance with electromagnetic interference (EMI) requirements.

In some examples, the reference node 202 is coupled to each phase of the input 102 via another type of impedance, such as respective resistors or a combination of resistors and capacitors.

The example phase detection circuit 128 detects whether single or three-phase power is applied to the input by measuring the frequency of the ripple voltage at the reference node 202. For a 60Hz waveform, the ripple frequency at the reference node 202 is expected to be about 120Hz for a single-phase input and about 180Hz for a three-phase input.

In the example of FIG. 2, the phase detection circuit 128 includes circuitry configured to measure the ripple frequency by measuring a time period between the rising edges of the ripple voltage and comparing against a threshold time period. For example, the phase detection circuit 128 AC-couples the signal through a series capacitor 210 and scales the signal down to a control voltage level. The phase detection circuit 128 then compares the scaled voltage to a substantially constant reference voltage.

Each time the ripple voltage goes above the reference voltage, a comparator 204 goes from a low state to a high state. In response to a rising edge output by the comparator 204, a processor or other logic circuit starts a time cycle corresponding to a time period between an expected time period for a single-phase ripple frequency (e.g., 8.3 milliseconds for 120 Hz) and an expected time period for a three-phase ripple frequency (e.g., 5.6 milliseconds for 180 Hz). If the time period times out at the processor 206 before the next rising edge of the ripple voltage from the comparator 204, the phase detection circuit 128 determines that a single-phase voltage is applied. Conversely, when the output from the comparator 204 is retriggered before the timeout at the processor 206, the phase detection circuit 128 determines that a three-phase voltage is present at the input 102. The processor 206 outputs a phase detection signal 208, which may be provided to the example control circuitry 122 of FIG. 1 to control the welding-type power supply 100 (e.g., control conversion of input power to welding-type power).

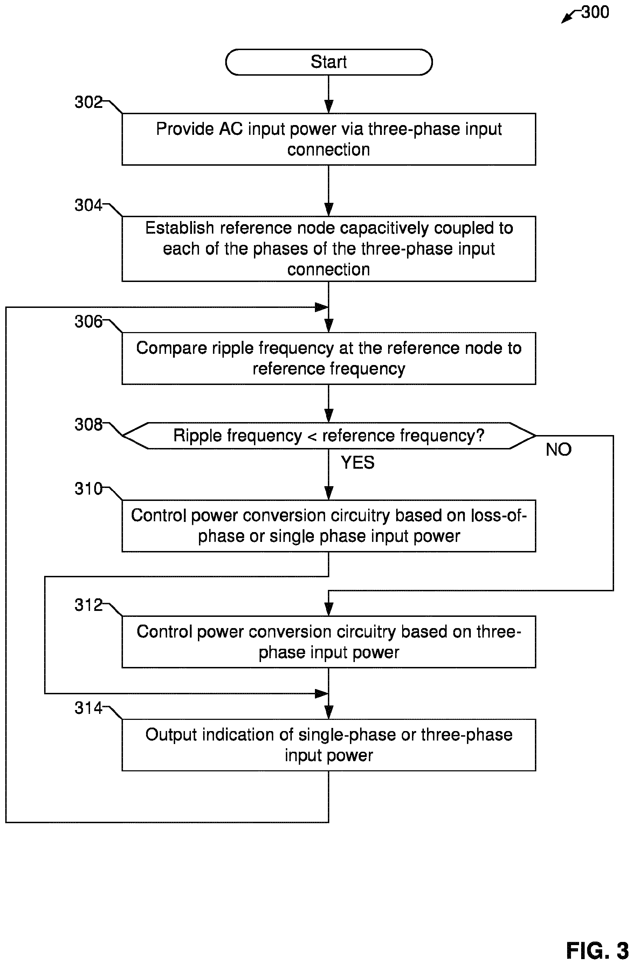

FIG. 3 is a flowchart representative of an example method 300 which may be performed by the welding-type power supply 100 of FIG. 1 to detect single-phase or three-phase input power, and to control a welding-type power supply based on the detection. The example method 300 is discussed below with reference to the power supply 100 and the phase detection circuit 128 of FIGS. 1 and 2.

At block 302, AC input power is provided via a three-phase input connection (e.g., the input 102 of FIGS. 1 and 2). The AC input power may be three-phase power or single-phase power connected to two of the three-phase input terminals.

At block 304, the phase detection circuit 128 establishes a reference node (e.g., the reference node 202) capacitively coupled to each of the phases of the three-phase input connection.

At block 306, the phase detection circuit 128 compares a frequency of a ripple signal on the reference node 202 to a reference frequency. In some examples, as described above with reference to FIG. 2, the phase detection circuit 128 compares the frequency to the reference frequency by measuring a time period of the ripple signal corresponding to the ripple frequency to a threshold time period.

At block 308, the phase detection circuit 128 determines whether the ripple frequency at the reference node 202 is less than the reference frequency. If the ripple frequency at the reference node 202 is less than the reference frequency (block 308), at block 310 the control circuitry 122 controls the power conversion circuitry 110 (e.g., in response to a signal from the phase detection circuit 128) based on a change-of-phase condition in the three-phase input and/or based on a single-phase AC input present at the input 102. For example, the control circuitry 122 may derate (e.g., reduce the output capability) of the power conversion circuitry 110 and/or the auxiliary power conversion circuitry 116, perform load shedding, change thermal limits such as shutdown temperatures, control output current, voltage, and/or power, and/or otherwise control the welding-type power supply 100 based on the presence of single-phase input power.

In some other examples, the control circuitry 122 may disable the output of the power conversion circuitry 110 at block 310 in response to detecting the change-of-phase or single-phase condition. For example, the control circuitry 122 may disconnect the power conversion circuitry 110 from an input power, disable switching elements or other hardware within the power conversion circuitry, and/or otherwise prevent the power conversion circuitry 110 from outputting welding-type power in response to detecting the change-of-phase or single-phase condition.

On the other hand, if the ripple frequency at the reference node 202 is greater than the reference frequency (block 308), at block 312 the control circuitry 122 controls the power conversion circuitry 110 (e.g., in response to a signal from the phase detection circuit 128) based on the presence of a three-phase input at the input 102. The control circuitry 122 may adjust one or more control or other variables based on the type of input signal detected by the phase detection circuit 128. For example, the control circuitry 122 may increase an output capability of the power conversion circuitry 110 and/or the auxiliary power conversion circuitry 116 relative to single-phase operation, change thermal limits such as shutdown temperatures, control output current, voltage, and/or power, and/or otherwise control the welding-type power supply 100 based on the presence of three-phase input power

At block 314, the control circuitry 122 outputs an indication of whether the input is single-phase (or loss-of-phase) or three-phase power. For example, the control circuitry 122 may control a user interface or output device to output an alert or notifications that the power supply 100 is operating on single-phase power, which may cause the operator to investigate or troubleshoot if the operator expects three-phase power to be present. Control then returns to block 306 to continue monitoring the input 102.

The control circuitry 122 of FIG. 1 and/or the processor 206 of FIG. 2 may include and/or be implemented using one or more microprocessors, such as one or more "general-purpose" microprocessors, one or more special-purpose microprocessors and/or ASICS, field programmable gate arrays (FPGAs), systems-on-a-chip (SoCs), and/or any other type of processing device. For example, the control circuitry 122 of FIG. 1 and/or the processor 206 may include one or more digital signal processors (DSPs).

The present methods and systems may be realized in hardware, software, and/or a combination of hardware and software. The present methods and/or systems may be realized in a centralized fashion in at least one computing system, or in a distributed fashion where different elements are spread across several interconnected computing systems. Any kind of computing system or other apparatus adapted for carrying out the methods described herein is suited. A typical combination of hardware and software may include a general-purpose computing system with a program or other code that, when being loaded and executed, controls the computing system such that it carries out the methods described herein. Another implementation may comprise an application specific integrated circuit or chip. Some implementations may comprise a non-transitory machine-readable (e.g., computer readable) medium (e.g., FLASH drive, optical disk, magnetic storage disk, or the like) having stored thereon one or more lines of code executable by a machine, thereby causing the machine to perform processes as described herein. As used herein, the term "non-transitory machine-readable medium" is defined to include all types of machine readable storage media and to exclude propagating signals.

As utilized herein the terms "circuits" and "circuitry" refer to physical electronic components, any analog and/or digital components, power and/or control elements, such as a microprocessor or digital signal processor (DSP), or the like, including discrete and/or integrated components, or portions and/or combination thereof (i.e. hardware) and any software and/or firmware ("code") which may configure the hardware, be executed by the hardware, and or otherwise be associated with the hardware. As used herein, for example, a particular processor and memory may comprise a first "circuit" when executing a first one or more lines of code and may comprise a second "circuit" when executing a second one or more lines of code. As utilized herein, "and/or" means any one or more of the items in the list joined by "and/or". As an example, "x and/or y" means any element of the three-element set {(x), (y), (x, y)}. In other words, "x and/or y" means "one or both of x and y". As another example, "x, y, and/or z" means any element of the seven-element set {(x), (y), (z), (x, y), (x, z), (y, z), (x, y, z)}. In other words, "x, y and/or z" means "one or more of x, y and z". As utilized herein, the term "exemplary" means serving as a non-limiting example, instance, or illustration. As utilized herein, the terms "e.g.," and "for example" set off lists of one or more non-limiting examples, instances, or illustrations. As utilized herein, circuitry is "operable" to perform a function whenever the circuitry comprises the necessary hardware and code (if any is necessary) to perform the function, regardless of whether performance of the function is disabled or not enabled (e.g., by a user-configurable setting, factory trim, etc.).

While the present method and/or system has been described with reference to certain implementations, it will be understood by those skilled in the art that various changes may be made and equivalents may be substituted without departing from the scope of the present method and/or system. For example, block and/or components of disclosed examples may be combined, divided, re-arranged, and/or otherwise modified. In addition, many modifications may be made to adapt a particular situation or material to the teachings of the present disclosure without departing from its scope. Therefore, the present method and/or system are not limited to the particular implementations disclosed. Instead, the present method and/or system will include all implementations falling within the scope of the appended claims, both literally and under the doctrine of equivalents.

## Claims

1. A welding-type power supply, comprising:
power conversion circuitry configured to convert three-phase input power to welding-type power;
a reference node coupled to each winding of the three-phase input power via a corresponding impedance; and
a phase detection circuit coupled to the reference node and configured to determine a number of phases connected to the input based on comparing a frequency of a signal at the reference node to a threshold frequency.

2. The welding-type power supply as defined in claim 1, wherein the reference node is coupled to each winding of the three-phase input power via a respective capacitor.

3. The welding-type power supply as defined in claim 2, wherein the respective capacitor is configured to perform filtering of the input to reduce electromagnetic emissions.

4. The welding-type power supply as defined in claim 1, further comprising control circuitry configured to control the power conversion circuitry based on whether single-phase power or three-phase power is detected on the input.

5. The welding-type power supply as defined in claim 4, wherein the control circuitry is configured to control at least one of an output current of the power conversion circuitry, an output voltage of the power conversion circuitry, an output power of the power conversion circuitry, a thermal shutdown limit, or output load shedding based on whether single-phase power or three-phase power is detected on the input.

6. The welding-type power supply as defined in claim 1, wherein the signal comprises a ripple signal at the reference node.

7. The welding-type power supply as defined in claim 6, wherein the ripple signal at the reference node is AC-coupled to the phase detection circuit.

8. The welding-type power supply as defined in claim 1, wherein the power conversion circuitry is further configured to convert single-phase input power to the welding-type power.

9. The welding-type power supply as defined in claim 1, wherein the control circuitry is configured to, in response to detecting single-phase input power via the phase detection circuit, at least one of output a notification, output an alarm, or disable output by the power conversion circuitry.

10. A method to determine a number of phases connected to the input of a welding-type power supply, the method comprising:
providing input power via a three-phase input connection to a welding-type power supply; and
determining a number of phases connected to the three-phase input connection based on comparing a frequency of a signal at a reference node to a threshold frequency, coupled to each winding of the three-phase input power via a corresponding impedance.

11. The method as defined in claim 10, wherein the reference node is capacitively coupled to each of the phases of the three-phase input connection.

12. The method as defined in claim 10, further comprising controlling power conversion circuitry to convert the input power to welding-type power based on the determined number of phases connected to the three-phase input connection.

13. The method as defined in claim 12, wherein the controlling the power conversion circuitry comprises controlling at least one of the output current of the power conversion circuitry, an output voltage of the power conversion circuitry, an output power of the power conversion circuitry, a thermal shutdown limit, or output load shedding based on whether single-phase power or three-phase power is detected on the three-phase input connection.

14. The method as defined in claim 10, wherein the determining the number of phases connected to the three-phase input connection comprises determining that three phases are connected to the three-phase input connection when the ripple frequency is at least the reference frequency.

15. The method as defined in claim 10, wherein the determining the number of phases connected to the three-phase input connection comprises determining that fewer than three phases are connected to the three-phase input connection when the ripple frequency is less than the reference frequency.
